# EUROPÄISCHE PATENTSCHRIFT

(11) **EP 0 401 771 B1**
(45) Veröffentlichungstag und Bekanntmachung des Hinweises auf die Patenterteilung: **20.09.1995**
(21) Anmeldenummer: 90110655.9
(22) Anmeldetag: 06.06.1990
(51) Int. Cl.: H03D 1/22, H03B 27/00

(54) **Schaltungsanordnung zur Frequenzumsetzung**
Circuit arrangement for frequency conversion
Montage de circuit pour conversion en fréquence

(30) Priorität: 09.06.1989 DE 3918829; 27.03.1990 DE 4009784
(43) Veröffentlichungstag der Anmeldung: 12.12.1990
(73) Patentinhaber: TEMIC TELEFUNKEN microelectronic GmbH, 74072 Heilbronn (DE)
(72) Erfinder: Tränkle, Günter, Dipl.-Ing., D-7900 Neu-Ulm (DE); Deckenbach, Gottfried, Dipl.-Ing. (FH), D-7906 Blaustein (DE)

(56) Entgegenhaltungen:
- EP-A- 0 048 229
- EP-A- 0 180 339
- DE-A- 2 645 950

## Beschreibung

Die Erfindung betrifft eine Schaltungsanordnung zur Frequenzumsetzung nach dem Oberbegriff des Patentanspruchs 1. Eine derartige Schaltungsanordnung ist aus der DE-A-2 645 950 bekannt.

In modernen Systemen der Nachrichten- und Ortungstechnik wird im Empfänger häufig eine Auswertung nach Betrag und Phase vorgenommen. Zur Berechnung der Phaseninformation ist eine orthogonale Aufspaltung des Empfangssignals in In-Phasenzweig (I) und Quadraturzweig (Q) erforderlich. Eine Schaltungseinheit, die durch eine komplexe Mischung mit anschließender Tiefpaßfilterung die beiden Quadratursignale erzeugt, wird als Quadratur- oder Vektor-Demodulator bezeichnet.

Meist werden mit dem Quadraturdemodulator aus der Zwischenfrequenzlage heraus digitalisierbare Basisbandsignale erzeugt. Prinzipiell kann aber auch das Empfangssignal in einem Schritt aus der Hochfrequenzlage mittels kohärenter oder asynchroner Direktmischung ins Basisband umgesetzt werden.

In entsprechender Weise wird das Prinzip der Quadratur-Signalverarbeitung zur Erzeugung eines Sendesignals aus einem Nutzsignal und einem Überlagerungssignal in einem Modulator angewandt. Schaltungsanordnungen für Modulatoren und Demodulatoren können in wesentlichen Teilen prinzipiell gleichartig aufgebaut sein.

Die eingangs genannte gattungsgemäße DE-A-2 645 950 beschreibt eine nach dem Prinzip der Quadratur-Signalverarbeitung arbeitende Schaltungsanordnung, bei der ein zweites Quadratur-Überlagerungssignal mittels einer Phasenregelschleife (PLL) aus einem ersten Quadratur-Überlagerungssignal erzeugt wird. Eine derartige Schaltungsanordnung weist jedoch wegen des begrenzten Arbeitsbereichs der PLL eine geringe Bandbreite auf. Außerdem werden, um den Störlinienanteil im zweiten Quadratur-Überlagerungssignal zu unterdrücken, hohe Anforderungen an die PLL und an das dieser zugeführte erste Quadratur-Überlagerungssignal gestellt. Zudem weisen die beiden Quadratur-Überlagerungssignale, da sie auf unterschiedliche Weise generiert werden, einen schlechten Amplitudengleichlauf auf.

Der vorliegenden Erfindung liegt die Aufgabe zugrunde, eine vorteilhafte Schaltungsanordnung zur Frequenzumsetzung für einen Modulator oder Demodulator anzugeben. Insbesondere soll eine solche Anordnung die folgenden Anforderungen erfüllen:
- hohe Spiegelfrequenzunterdrückung, d. h. kleine Quadraturfehler und gutes Amplitudenmatching,
- geringe Phasenfehler auch bei verzerrtem Lokaloszillator (LO)-Signal,
- hohe LO → RF-Isolation (unterbindet bei Direktumsetzung Offsetentstehung durch LO-Selbstmischung),
- Breitbandtauglichkeit,
- geringer Intermodulations- und Rauschbeitrag,
- hohe Regeldynamik in Verbindung mit DC-stabilen Ausgängen und konstanter Linearitätseigenschaften,
- geringer Leistungsbedarf,
- geringe Außenbeschaltung.

Die Erfindung ist im Patentanspruch 1 beschrieben. Die Unteransprüche enthalten vorteilhafte Ausgestaltungen und Weiterbildungen der Erfindung.

Die Erfindung ist nachfolgend unter Bezugnahme auf die Abbildungen anhand von Ausführungsbeispielen noch eingehend veranschaulicht. Dabei zeigt
- FIG. 1:: den prinzipiellen Aufbau eines direkt umsetzenden Empfängers
- FIG. 2:: den prinzipiellen Aufbau einer Sendeanordnung
- FIG. 3:: ein Blockschaltbild eines Quadratur-Demodulators
- FIG. 4:: ein Blockschaltbild eines Überlagerungssignalgenerators zur Erzeugung orthogonaler Signale
- FIG. 5:: eine bevorzugte Ausführungsform eines Generators für Quadratur-Überlagerungssignale
- FIG. 6:: ein Blockschaltbild einer Quadratur-Mischeranordnung mit einer regelbaren Spannungs-Strom-Wandlerstufe
- FIG. 7:: den Aufbau einer Frequenzverdopplerstufe
- FIG. 8:: ein verzerrtes Oszillatorsignal und eine spektrale Verteilung von Amplidudenverhältnissen.

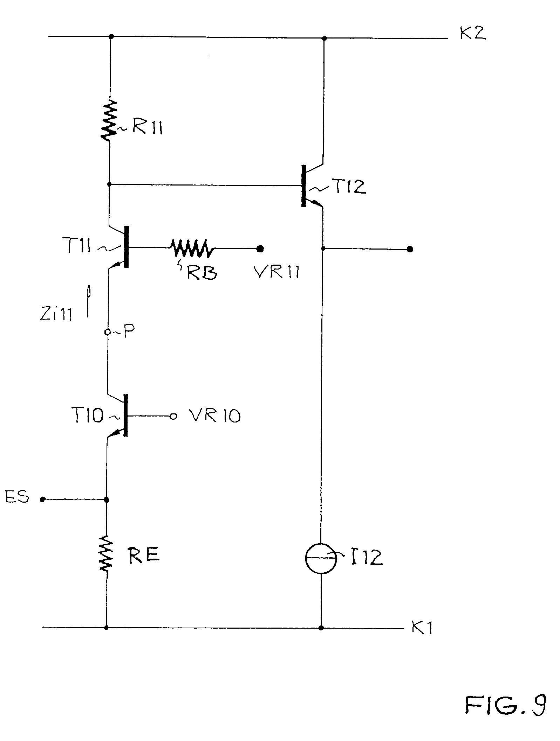

- FIG. 9:: eine bevorzugte Ausführung eines Vorverstärkers.

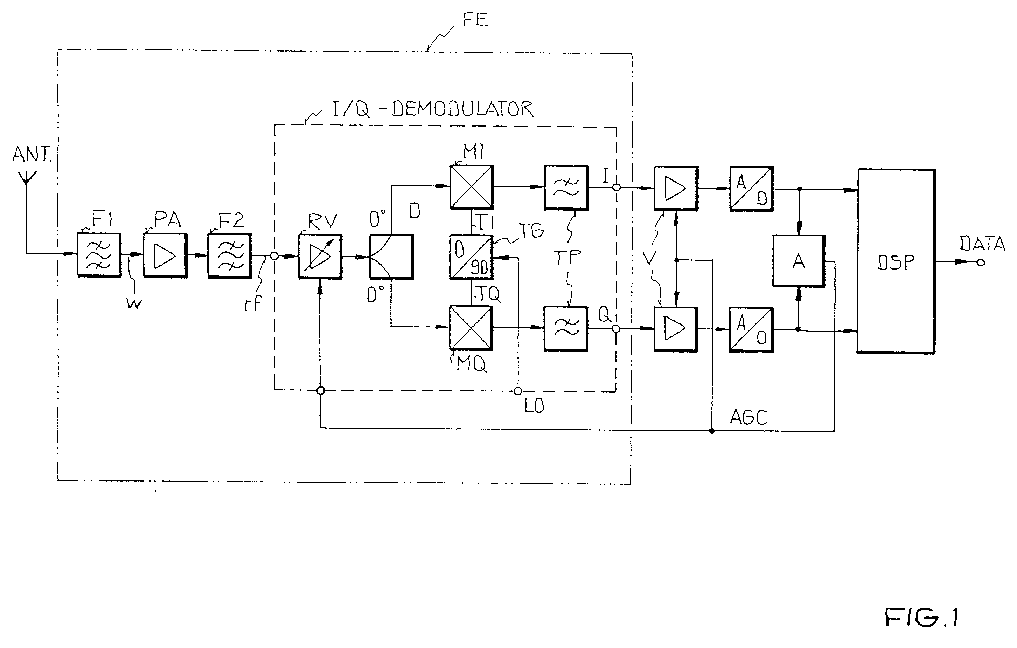

Die Skizze nach FIG. 1 zeigt in vereinfachter Form ein Eingangsteil (Front End) FE einer Empfänger-Anordnung zur Direktumsetzung eines über eine Antenne ANT aufgenommenen hochfrequenten Datensignals ins Basisband und die nachfolgende Rückgewinnung der z. B. phasenmodulierten Daten.

Das über die Antenne aufgenommene und in einem ersten Filter F1 gefilterte Empfangssignal w wird in einem Vorverstärker PA verstärkt und nach Durchlaufen eines gegebenenfalls weiteren Filters F2 als hochfrequentes Signal rf auf den Signaleingang des Quadratur (I/Q-Demodulators geleitet.

Das Vorfilter F1 (zum Teil auch F2) reduziert die Anforderungen an die Störfestigkeit der aktiven Komponenten des Front Ends und verhindert den Empfang an Frequenzpunkten der Oszillatoroberwellen. Das Filter F2 wird eingesetzt, falls Störkomponenten, die im Verstärker PA entstehen (Offset, harmonische Verzerrungen), unterdrückt werden müssen.

Im I/Q-Demodulator wird das hochfrequente Signal rf in einem regelbaren Verstärker RV verstärkt und in einer Aufteilstufe auf zwei Signalzweige gleicher Phase verteilt und in Mischern MI, MQ mit Überlagerungssignalen TI, TQ umgesetzt. Die Überlagerungssignale TI, TQ sind mittels eines Überlagerungssignal-Generators TG aus einem Oszillatorsignal LO eines Überlagerungsoszillators abgeleitet und weisen eine gegenseitige Phasenverschiebung von 90° auf. Aus den Mischerausgangssignalen werden durch Tiefpaßfilter TP die Komponenten I und Q des komplexen Basisbandsignals gewonnen. Die Direktumsetzung ins Basisband speziell bei kohärenter Umsetzung hat einige wesentliche Vorteile gegenüber dem Superhet-Prinzip mit Zwischenfrequenz. Insbesondere tritt das Problem der Spiegelfrequenzunterdrückung nicht auf, und die Kanalhauptselektion kann im Basisband mit monolithisch integrierbaren anti-aliasing-Tiefpaßfiltern und Digital-Tiefpaßfiltern vorgenommen werden.

Das komplexe Basisbandsignal mit Komponenten I und Q wird in weiteren regelbaren Verstärkern V nochmals verstärkt und gefiltert und nach Analog/Digitalwandlung in einem digitalen Signalprozessor DSP zur Rückgewinnung der Daten DATA ausgewertet. In einem Amplitudendetektor A können aus der Quadratsumme der beiden Komponenten Regelsignale zur automatischen Verstärkungsregelung AGC der regelbaren Verstärker RV und V abgeleitet werden.

Analog zu FIG. 1 aufgebaut ist eine Senderanordnung mit einem I/Q-Modulator mit entsprechend umgekehrter Signallaufrichtung. Ein als komplexes Basisbandsignal vorliegendes niederfrequentes Datensignal DATA ist nach seinem beiden orthogonalen Komponenten I und Q getrennt den Mischern MI bzw. MQ zugeführt und wird dort mit den aus dem Oszillatorsignal LO im Überlagerungssignal-Generator TG gewonnenen orthogonalen Überlagerungssignalen TI bzw. TQ umgesetzt. Die Mischerausgangssignale werden zu dem hochfrequenten Ausgangssignal rf zusammengefaßt, das in einer Sendeverstärkerstufe SV verstärkt und über die Antenne ANT abgestrahlt wird. Zwischen den Mischerausgängen und der Sendeverstärkerstufe SV kann noch eine Filterstufe FS vorgesehen sein.

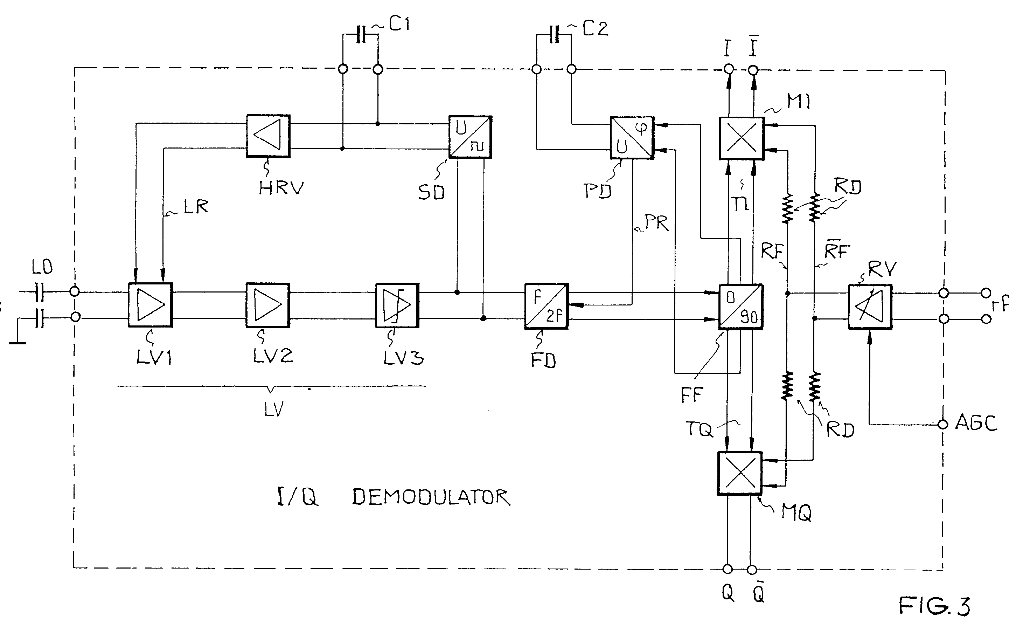

FIG. 3 zeigt ein detaillierteres Blockschaltbild des Quadratur-Demodulators von FIG. 1. Das vorverstärkte und gegebenenfalls gefilterte hochfrequente Signal rf liegt am Eingang des regelbaren Breitbandverstärkers RV, dessen Verstärkung durch die zu FIG. 1 bereits beschriebene AGC-Schleife einstellbar ist. Der Verstärker RV weist zwei Ausgänge auf, an denen das verstärkte hochfrequente Signal in Form gegenphasiger Signalanteile RF, R̅F̅ auftritt. Die beiden gegenphasigen Ausgangssignale werden jeweils in zwei gleiche Teile aufgeteilt und den beiden Mischern MI, MQ zugeführt.

Die gleichmäßige Aufteilung sei in der Abbildung durch gleiche Widerstände RD in den Verbindungen zwischen Mischern MI, MQ und Verstärker RV repräsentiert. Der Mischer MI ist durch das Überlagerungssignal TI, der Mischer MQ durch das dazu um 90° phasenverschobene Überlagerungssignal TQ angesteuert. Die Gegentakt-Ausgangssignale der Mischer sind mit I, I̅ bzw. Q, Q̅ bezeichnet.

Bei den Überlagerungssignalen TI, TQ, die vorzugsweise Rechteck-Schaltsignale sind, ist die genaue Einhaltung der gegenseitigen 90° Phasenverschiebung sowie der Halbwellensymmetrie in den beiden Überlagerungssignalen von wesentlicher Bedeutung.

Die Anordnung nach FIG. 3 sieht hierzu vor, daß ein Oszillatorsignal LO von einem Überlagerungs-Oszillator, an das keine besonders hohen Anforderungen gestellt sind, im I/Q-Demodulator aufbereitet wird zu den Überlagerungssignalen TI, TQ.

Das Oszillatorsignal LO ist an den Eingang einer aus mehreren Verstärkerstufen LV1, LV2, LV3, von denen die letzte (LV3) vorzugsweise in die Begrenzung gesteuert ist, aufgebauten Verstärkeranordnung LV gelegt.

Das Ausgangssignal der letzten Verstärkerstufe LV3 ist einem Detektor SD zugeführt, der fortlaufend das Tastverhältnis des begrenzten Ausgangssignals detektiert und bei von 0,5 abweichendem Tastverhältnis über einen Regelverstärker HRV ein Regelsignal LR für die erste Verstärkerstufe LV1 erzeugt, das der Unsymmetrie entgegenwirkt, beispielsweise durch eine Gleichspannungs-Pegelverschiebung des Eingangs- oder Ausgangssignals der ersten Verstärkerstufe, wodurch sich der Schaltzeitpunkt des Verstärkers ändert. Durch den externen Kondensator C1 ist die Regelzeitkonstante der Regelschleife einstellbar. Das Ausgangssignal der letzten Verstärkerstufe LV3, für welches durch die Regelschleife mit SD und HRV Halbwellensymmetrie (Tastverhältnis 0,5) gewährleistet ist, ist an den Eingang einer Frequenzverdopplungsschaltung FD gelegt, die ein Signal doppelter Frequenz abgibt. Bei guter Halbwellensymmetrie des Signals am Eingang von FD ist die Grundwelle im Ausgangssignal von FD weitestgehend unterdrückt. Die Begrenzung des Signals durch den Verstärker ist lediglich eine vorteilhafte Ausführungsform. Das Oszillatorsignal kann auch linear verstärkt oder nur schwach begrenzt werden.

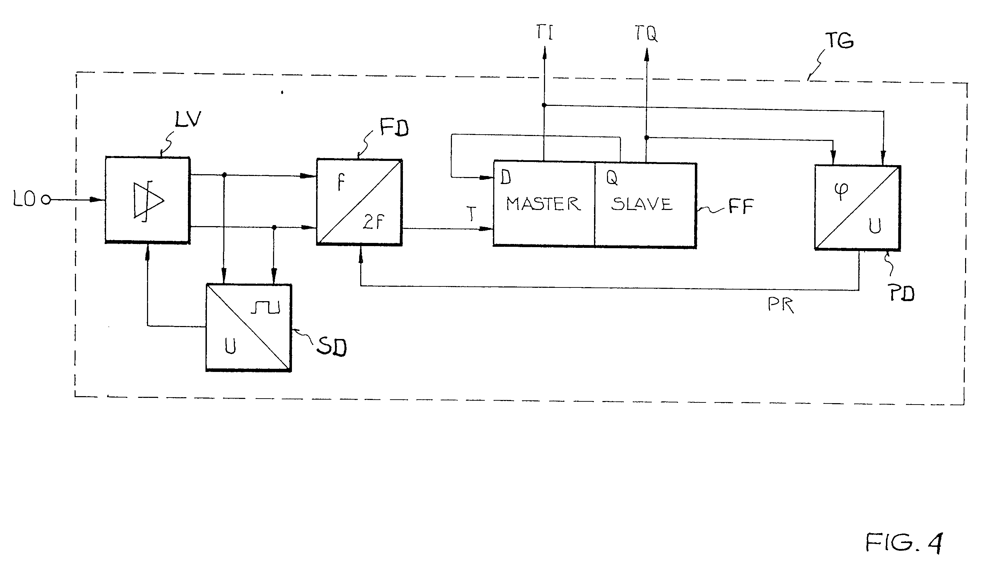

Das frequenzverdoppelte Signal am Ausgang von FD ist einem Master-Slave-D-Flip-Flop FF in Toggle-Betriebsschaltung zugeführt, das als Frequenzteiler wirkt, so daß die Ausgangssignale TI, TQ des Flip-Flops FF wieder dieselbe Frequenz wie das Oszillatorsignal LO haben. Das Flip-Flop FF kann als Phasenaufteiler zur Erzeugung von zwei um 90° phasenverschobenen Überlagerungssignalen TI, TQ eingesetzt werden, indem, wie in FIG. 4 skizziert, der Ausgang der Master-Stufe das eine (TI), der Ausgang der Slave-Stufe das andere (TQ) Überlagerungssignal liefert. Aufgrund dynamischer Effekte ist die 90°-Phasenbeziehung zwischen TI und TQ vor allem für sehr hohe Frequenzen nicht ohne weiteres mit ausreichender Genauigkeit sichergestellt. Mittels eines Phasendetektors PD, der die Orthogonalität der Überlagerungssignale TI, TQ überwacht und bei Abweichungen ein Regelsignal PR für die Frequenzverdopplerschaltung FD erzeugt, kann aber auf einfache Weise eine wirkungsvolle Ausregelung von Phasenfehlern erreicht werden. Das Regelsignal kann beispielsweise eine Gleichspannungsverschiebung des frequenzverdoppelten Signals, das durch die Begrenzerverstärkeranordnung LV in Verbindung mit der Halbwellensymmetrie-Regelschleife (SD) eine hohe Grundwellenfreiheit aufweist, bewirken, wodurch sich der Schaltzeitpunkt des FF-Taktstromschalters beeinflussen läßt. Die Regelzeitkonstante der Phasenregelschleife mit Phasendetektor PD ist durch den externen Kondensator C2 bestimmt.

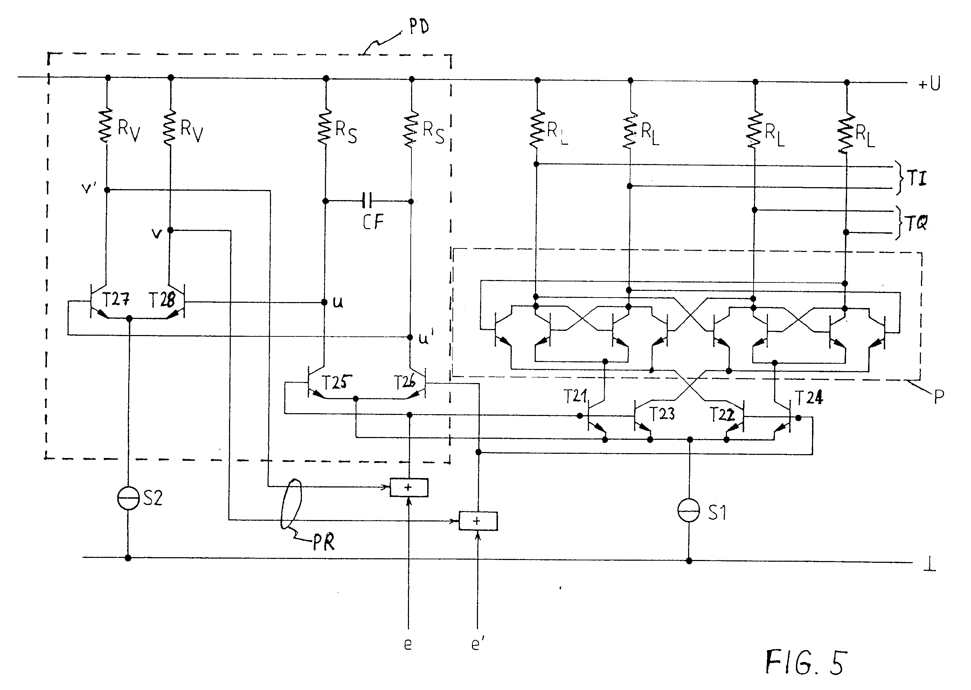

Während bei der in FIG. 4 skizzierten Anordnung das Regelsignal PR aus den Ausgangssignalen des Flip-Flops abgeleitet ist, sieht eine bevorzugte Ausführungsform die Gewinnung des Regelsignals mittels eines mit den Eingängen des phasenteilenden Flip-Flops (bzw. den Ausgängen der Frequenzverdopplerstufe FD) verbundenen Phasendetektors vor, wie nachfolgend anhand der FIG. 5 beschrieben.

Das im Block P skizzierte Master-Slave-D-Flip-Flop als solches ist einschließlich seiner Funktion hinlänglich bekannt, weshalb die Transistoren im Block P nicht einzeln bezeichnet und die Wirkungsweise der einzelnen Rückkopplungen nicht weiter beschrieben sind. Andere Flip-Flop-Schaltungen sind in entsprechender Weise verwendbar. An den über Lastimpedanzen R_{L} mit dem Versorgungspotential +U verbundenen Master- und Slave-Ausgängen sind die beiden 90°-phasenverschobenen Ausgangssignale TI und TQ abgegriffen.

Die Master- und Slave-Stufen sind durch zwei als Differenzverstärker ausgeführte Stromschalter T21, T22 bzw. T23, T24 angesteuert, deren Eingänge mit dem symmetrisch zugefuhrten Eingangssignal e, e′ beaufschlagt sind. Entsprechende Eingänge der beiden Differenzverstärker sind miteinander verbunden. (Basis von T21 mit Basis von T23; Basis von T22 mit Basis von T24) Beide Differenzverstärker sind aus einer gemeinsamen Stromquelle S1 gespeist. Durch den hochsymmetrischen Aufbau und die bei monolithischer Integration gegebene Möglichkeit, einzelne Schaltungselemente in guter Genauigkeit mit gleichen Eigenschaften herzustellen, sind keine durch den Aufbau des Flip-Flops samt Stromschalter und Stromquelle verursachten Phasenfehler zu erwarten.

Phasenfehler treten aber auf, wenn das Tastverhältnis der Stromschalter ≠ 0,5 ist, d. h. wenn die Schaltzeitpunkte nicht zeitlich äquidistant liegen. Dies ist auf kaum mit vertretbarem Aufwand vermeidbare Verzerrungen des Eingangssignals e, e′ zurückzuführen, das wegen der 2:1-Frequenzteilerwirkung des als statischer Phasenteiler betriebenen Flip-Flops im vorliegenden Fall das Ausgangssignal T des Frequenzverdopplers ist.

Kann mittels eines Regelkreises ein Tastverhältnis von 0,5 eingeregelt werden, so ist auch die gewünschte 90°-Phasenlage der Ausgangsspannung TI und TQ gewährleistet.

Im skizzierten bevorzugtem Beispiel ist zur Überwachung des Tastverhältnisses ein weiteres als Differenzverstärker aufgebauter Stromschalter mit Transistoren T25, T26 vorgesehen. Dieser Stromschalter soll dieselben Schalteigenschaften besitzen wie die Stromschalter T21, T22 und T23, T24, was wiederum bei monolithischer Integration mit guter Genauigkeit erzielt werden kann. Die Eingänge des weiteren Stromschalters T25, T26 sind mit den entsprechenden Eingängen der beiden anderen Stromschalter T21, T22 und T23, T24 unmittelbar verbunden und so ebenfalls mit dem Eingangssignal e, e′ beaufschlagt. Wesentlich ist, daß die Schaltzeitpunkte aller Stromschalter exakt übereinstimmen.

Zur weiteren Angleichung der dynamischen Eigenschaften des weiteren Stromschalters an die der anderen Stromschalter sind alle Stromschalter aus der gemeinsamen Stromquelle S1 gespeist.

Zwischen die über Lastwiderstände R_{S} mit dem Versorgungspotential verbundenen Ausgänge des weiteren Stromschalters T25, T26 ist eine Kapazität CF geschaltet, die zusammen mit den Lastwiderständen einen Tiefpaß zur Mittelung der Ausgangsspannung u, u′ des weiteren Stromschalters bildet.

Bei von 0,5 verschiedenem Tastverhältnis, z. B. bei länger aussteuernder positiver Halbwelle für e und kürzerer positiver Halbwelle im komplementären Signal e′ ist jeweils einer der beiden Transistoren aller drei Stromschalter länger geöffnet als der andere, bei dem weiteren Stromschalter im Beispielsfall der Transistor T25, so daß die gemittelte Ausgangsspannung u gegenüber u′ niedriger liegt.

Die Ausgangsspannungen u, u′ des weiteren Stromschalters T25, T26 sind an die Eingänge eines Regel-Differenzverstärkers zur Erhöhung der Schleifenverstärkung des Regelkreises und somit zur Minderung des Phasenrestfehlers mit Transistoren T27, T28 gelegt. Der Strom durch den Differenzverstärker ist durch die Stromquelle S2 festgelegt. Die Ausgänge des Regel-Differenzverstärkers sind über Lastwiderstände R_{V} mit Versorgungspotential +U verbunden. Die Ausgangsspannungen sind als Regelspannung v, v′ angegeben.

Wenn u gegenüber u′ absinkt, so führt dies zu einem verstärkten Ansteigen von v und einem entsprechenden Absinken von v′. Die Regelspannungen wirken unmittelbar verschiebend auf die Gleichspannungspegel an den Eingängen der Stromschalter (Additionsstufen +), so daß im Beispielsfall ein Anstieg von v zu einer Anhebung des Gleichspannungspegels an der Basis von T26 führt, was wiederum eine Verlängerung der aussteuernden Halbwelle von e′ und damit zu einer längeren Öffnungszeit des Transistors T26 und zum Absinken der Spannung u′ gegenüber u führt. Die entsprechende gegenteilige Rückwirkung einer Veränderung von v′ auf u führt zum Ansteigen von u und wirkt daher dem auslösenden Absinken von u entgegen. Der Regelkreis ist demnach bestrebt, die Spannungsdifferenz zwischen u und u′ zum Verschwinden zu bringen, was gleichbedeutend ist mit einem Tastverhältnis gleich 0,5 bzw. zeitlich äquidistanter Lage der Schaltzeitpunkte. Der beschriebene Regelkreis ist also mit einfachen Mitteln in der Lage, über die Einregelung des Tastverhältnisses in den Stromschaltern die 90°-Phasenlage in den Ausgangssignalen TI und TQ sicherzustellen.

Selbstverständlich kann auch eine unsymmetrische Ansteuerung der Stromschalter durch das Eingangssignal erfolgen, wobei dann einer der gemeinsamen Steueranschlüsse der Stromschalter auf konstantem Potential liegt. Die Regelfunktion bleibt in entsprechender Weise erhalten.

Die in FIG. 5 beschriebene Anordnung macht sich die Erkenntnis zunutze, daß bei genau äquidistanten Schaltzeitpunkten der die Master- und Slave-Stufe ansteuernden, von dem Eingangssignal beaufschlagten Stromschalter die 90°-Phasenbeziehung in den Ausgangssignalen gewährleistet ist, so daß durch eine Regelung der Schaltzeitpunkte auf zeitliche Äquidistanz die gewünschte Phasenlage sichergestellt ist und nicht mehr überprüft zu werden braucht.

Der beschriebene Regelkreis für das Tastverhältnis am Eingang bzw. die 90°-Phasenverschiebung am Ausgang des als Phasenteiler arbeitenden Flip-Flops ist nicht nur in dem engeren Zusammenhang mit einem Modulator oder Demodulator verwendbar, sondern allgemein zur Erzeugung von zwei Ausgangssignalen mit definierter Phasenbeziehung geeignet.

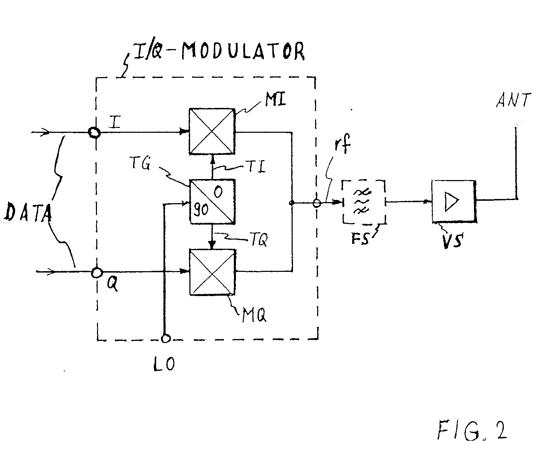

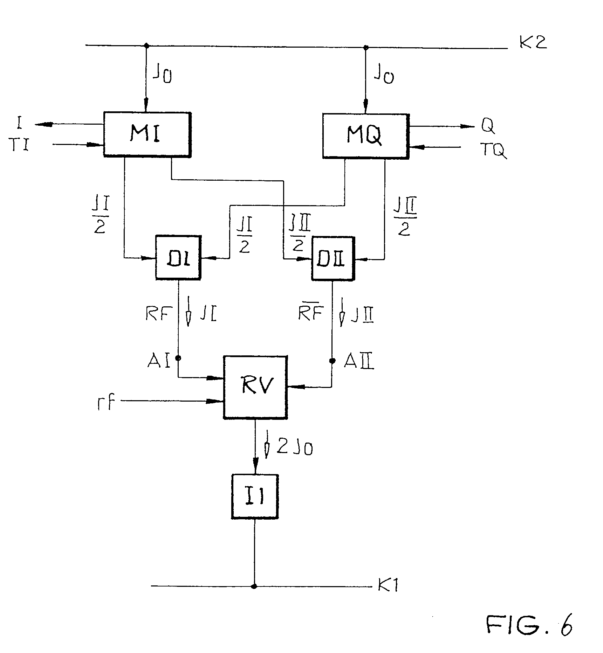

In FIG. 6 ist eine vorteilhafte kaskadierte Anordnung von regelbarem Verstärker RV und Mischern MI, MQ skizziert. Mit K1, K2 seien die Versorgungsspannungsanschlüsse bezeichnet. Der regelbare Verstärker RV enthalte als Eingangsstufe eine gegengekoppelte Differenzverstärkerstufe als Spannungs-Strom-Wandler für das hochfrequente Signal rf. Der Ruhestrom des Verstärkers RV ist durch die Konstantstromquelle I1 auf 2J_{O} festgelegt. Der Verstärker RV enthalte, ohne daß dies im Detail dargestellt ist, zudem eine von einem AGC-Regelsignal gesteuerte Regelstufe und Einrichtungen zur regelstellungsunabhängigen Konstanthaltung der Ruheströme in den Ausgangsströmen JI, JII an den Gegentakt-Ausgängen AI, AII des Verstärkers. Ein derartiger Verstärker ist beispielsweise beschrieben in der US-Patentanmeldung mit der Serial-Nr. 07/352 546. Die Ausgangsströme JI, JII setzen sich zusammen aus konstanten Ruhestromanteilen J_{O} und Signalstromanteilen RF, R̅F̅, die das verstärkte Eingangssignal rf repräsentieren. Die Signalstromanteile RF und R̅F̅ sind gegenphasig zueinander. Für jeden der beiden Ausgangsströme JI, JII ist in einer Aufteilstufe ein Stromteiler DI bzw. DII vorgesehen. Die Stromteiler können wie in FIG. 2 durch gleiche Widerstände RD aufgebaut sein, können aber auch Differenzverstärker zur gleichmäßigen Stromaufteilung enthalten.

Eine weitere vorteilhafte Ausführungsform sieht vor, daß die Aufteilung in der Weise erfolgt, daß jeder der beiden Signalzweige des Differenzverstärkers jeweils zwei gleiche, an Basis und Emitter verbundene Transistoren mit getrennten Kollektoren enthält. Eine solche Anordnung führt auf einfache Weise zu einer zuverlässigen Gleichaufteilung.

Die Mischer MI, MQ seien als sogenannte Gilbert-Mischer (Vierquadranten-Multiplizierer, Double-Balanced-Mixer) aufgebaut und durch die Signale TI, TQ vorzugsweise im Schaltmodus betrieben. In den Mischerausgangssignalen sind dann Signalanteile bei der Frequenz der Überlagerungssignale bereits weitgehend unterdrückt.

Der besondere Vorteil der Anordnung nach FIG. 6 liegt darin, daß durch die Kaskadierung der parallel angeordneten Mischer MI, MQ mit einer gemeinsamen Spannungs-Strom-Wandlerstufe in der Spannungs-Strom-Wandlerstufe der Summenstrom 2J_{O} der beiden jeweils durch die Mischer fließenden Betriebsströme J_{O} zur Verfügung steht und damit bessere Eigenschaften der z. T. gegenläufigen Anforderungen an hohe Linearität und geringen Stromverbrauch verbunden sind. Außerdem wird auf einfache Weise eine gute Amplitudengleichheit (amplitude matching) in I- und Q-Kanal erreicht.

Die Kaskadierung eines Verstärkers, vorzugsweise eines regelbaren Differenzverstärkers, mit einem Mischer ist allgemein von Vorteil durch die günstigen Eigenschaften hinsichtlich Stromverbrauch und Linearität und durch die einfache und zuverlässige Aufteilung (amplitude matching).

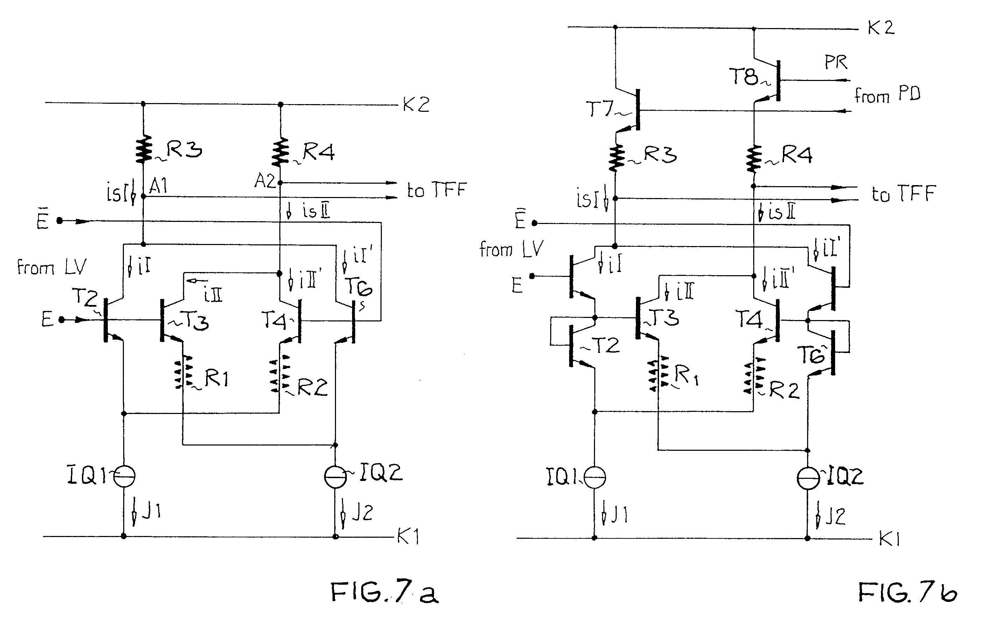

In FIG. 7 sind zwei Ausführungen für den Aufbau einer Frequenzverdopplerstufe skizziert. Bei der Ausführung nach FIG. 7 (a) verteilen sich bei balancierten Eingängen E, E̅, d. h. E und E̅ auf gleichem Gleichspannungspotential, die von den Stromquellen IQ1 und IQ2 festgelegten Ströme J1 bzw. J2 gemäß den unterschiedlich bemessenen Emitterflächen der Transistoren T2 und T4 bei Quelle IQ1 bzw. der Transistoren T6 und T3 bei Quelle IQ2. Die Emitterflächen sind so bemessen, daß durch Transistor T2 ein deutlich höherer Strom fließt als durch Transistor T4 bzw. durch Transistor T6 ein deutlich höherer Strom als durch Transistor T3. Die ungleiche Stromaufteilung kann anstelle unterschiedlich bemessener Emitterflächen auch durch unterschiedliche Gegenkopplung der Transistoren T2 und T4 bzw. T3 und T6 bei gleich großen Emitterflächen erfolgen. In der Abbildung ist dies angedeutet durch die mit unterbrochenen Linien eingetragenen Gegekopplungswiderstände R1, R2. Die Transistoren T2 und T4 und die Transistoren T6 und T3 bilden jeweils einen Differenzverstärker mit ungleicher Ruhestromaufteilung.

Bei Wechselspannungsansteuerung der Eingänge E, E̅ wird die Stromaufteilung im Takt des Wechselsignals verändert. Wegen der im Ruhezustand eingestellten deutlichen Ungleichheit der Ruhestromaufteilung ist bei der Wechselspannungsansteuerung aber nur die Stromumverteilung von den Transistoren mit größerer Emitterfläche (oder geringerer Gegenkopplung) T2 bzw. T6 auf die Transistoren mit kleinerer Emitterfläche (oder stärkerer Gegenkopplung R1, R2) T3 bzw. T4 quantitativ von Bedeutung. Jede Halbwelle des Eingangssignals an E, E̅ bewirkt eine Stromumverteilung von einem der anfänglich mehr Strom führenden Pfade (T2, T6) auf einen der anfänglich weniger Strom führenden Pfade (T3, T4), so daß in den Ausgangssummenströmen isI = iI + iI′ und isII = iII + iII′ ein komplementärer Anstieg und Abfall mit gegenüber dem Eingangssignal doppelter Frequenz erfolgt. Über den Spannungsabfall an den Lastwiderständen R3 und R4 ergibt sich daraus an den Ausgangsanschlußpunkten A1, A2 ein Wechselsignal mit gegenüber dem Eingangssignal verdoppelter Frequenz, das zur Ansteuerung des Toggle-Flip-Flops FF (FIG. 3, 4, 5) dient.

Die in FIG. 7 (b) skizzierte bevorzugte Ausführung der Frequenzverdopplerschaltung unterscheidet sich von der vorstehend beschriebenen im wesentlichen durch die zusätzlichen Transistoren T1, T5, T7 und T8. Die Transistoren T1 und T5 bewirken eine Erhöhung der Eingangsimpedanz. Durch die in die Ausgangssummenstrompfade eingefügten Transistoren T7, T8 in Kollektorbasisschaltung können die Gleichspannungspegel an A1 und A2 eingestellt werden. Die Transistoren T7, T8 bilden somit eine vorteilhafte Ausführungsform der in FIG. 5 eingezeichneten Additionsstufen. Bei Ansteuerung der Basen der Transistoren T7, T8 durch ein im Phasendetektor PD (FIG. 2, 3) erzeugtes Regelsignal PR kann so über eine Gleichspannungsverschiebung des frequenzverdoppelten Signals eine Regelung der 90°-Phasenverschiebung in den Ausgangssignalen TI, TQ des Toggle-Flip-Flops TFF vorgenommen werden. Die Regelung der 90°-Phasenlage der Flip-Flop-Ausgangssignale durch Gleichspannungsverschiebung des Flip-Flop-Eingangssignals ist in gleicher Weise anwendbar ohne die spezielle Frequenzverdopplungsanordnung.

Besondere Vorzüge der beschriebenen Frequenzverdopplerschaltung sind
- gutes dynamisches Verhalten
- symmetrischer Ausgang
- hoher Amplitudenumsetzungsfaktor k=A_{2f}/A_{f} bei relativ geringem Stromverbrauch
- Ansteuerung mit symmetrischem oder unsymmetrischem Eingangssignal möglich.

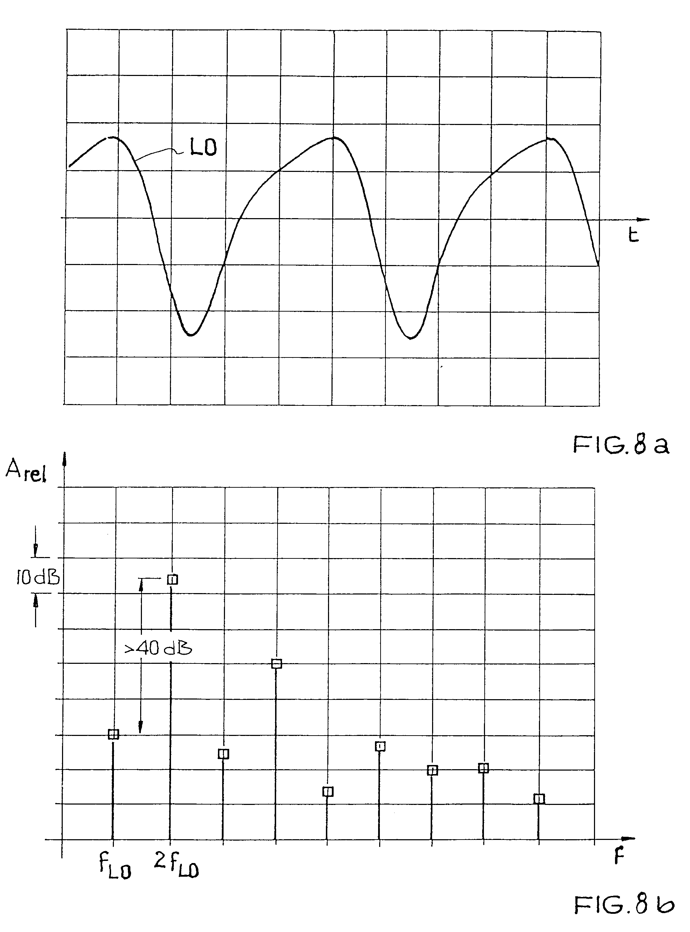

In FIG. 8 sind die Eigenschaften der Frequenzverdopplungsschaltung FD in Verbindung mit der auf Tastverhältnis 0,5 geregelten Verstärkeranordnung LV skizziert. Auch bei einem deutlich verzerrten Oszillatorsignal wie in FIG. 8 (a) skizziert, weist das Ausgangssignal der Freqenzverdopplungsschaltung, deren spektrale Antwort in FIG. 8 (b) als relative Amplituden (Arel) über der Frequenz f aufgetragen ist, eine hohe Grundwellenunterdrückung mit einem Amplitudenabstand von mehr als 40 dB zwischen Grundwelle bei f_{LO} und verdoppelter Frequenz 2f_{LO} auf. Die Signalanteile bei f=4f_{LO} verzerren das frequenzverdoppelte Signal immer in gleicher Richtung und führen dadurch zu keiner Störung bei der nachfolgenden Frequenzteilung mit Phasenregelung zur Erzeugung orthogonaler Signale.

Für die spezielle beschriebene Frequenzverdopplerschaltung sind Ansteuersignale E, E̅ mit geringer Flankensteilheit wie nicht begrenzte oder schwach begrenzte Signale von Vorteil, während für die Tastverhältnisregelung des Verstärkers LV begrenzte (Ausgangs-)/Signale von Vorteil sind. Vorzugsweise zeigt daher die Verbindung des Ausgangs des Verstärkers LV mit dem Eingang der Frequenzverdopplerstufe Tiefpaßcharakter. Für hohe Frequenzen wird ein solches Tiefpaßverhalten bereits durch die dynamischen Eigenschaften der verwendeten Bauelemente selbst in ausreichendem Umfang erzielt. Für tiefere Frequenzen ist vorteilhafterweise zwischen Verstärker LV und Frequenzverdopplerstufe FD ein Tiefpaßfilter vorgesehen, das für besonders breite Betriebsfrequenzbereiche auch einstellbar ist, z. B. mittels spannungsgesteuerter Kapazitätsdioden. An den Ausgängen der Frequenzverdopplerstufen bilden die Lastwiderstände R3, R4 mit den Kollektor-Kapazitäten der Transistoren gleichfalls Tiefpässe, die Signalanteile bei Frequenzen von 3f_{LO} und höher stärker dämpfen als das Ausgangsnutzsignal bei 2f_{LO}.

Die in FIG. 7 skizzierte Ausführung eines Vorverstärkers für eine Empfängeranordnung wie in FIG. 2 besteht im wesentlichen aus zwei in Reihe geschalteten Transistoren T10 und T11 in Basisschaltung. Der Emitter von T10 ist mit dem Signaleingang S und über eine Impedanz RE, die den Ruhestrom festlegt, mit dem einen Pol K1 der Versorgungsspannung, der Kollektor von T11 mit einer Auskoppelstufe und über einen Lastwiderstand R11 mit dem anderen Pol K2 der Versorgungsspannung verbunden. Als Auskoppelstufe ist im Beispielsfall ein Emitterfolger aus dem Transistor T12 und der Stromquelle T12 gewählt. Andere Ausführungen zur Signalauskopplung, z. B. eine open-collector-Auskopplung an T11 bei Verwendung einer externen Last, sind ebenso möglich und an sich bekannt. Die Basen von T10 und T11 liegen auf konstanten Potentialen VR10 bzw. VR11.

Die Transistoren T10, T11 sind ungleich ausgeführt in der Weise, daß für den Transistor T10 eine wesentlich großflächigere Struktur gewählt ist als für den Transistor T11. Daraus ergibt sich die Kombination einer rauscharmen Eingangsstufe T10 mit einer kleinen Ausgangsstufe T11 mit entsprechend hoher Grenzfrequenz. Da die Eingangsimpedanz Zᵢ₁₁ von T11 einen induktiven Charakter hat und quantitativ vom Basisbahnwiderstand von T11 bzw. einem zusätzlichen Basiswiderstand R_{B} abhängig ist, kann in Verbindung mit den am Verbindungspunkt PT wirksamen Kapazitäten durch Wahl der Flachenverhältnisse von T10 und T11 eine Verstärkungsanhebung (peaking) insbesondere für sehr hohe Frequenzen erzielt werden.

Bei Ausführung des Vorverstärkers als monolithisch integrierte Schaltung kann überdies eine sehr gute Rückwärtsisolation erreicht werden, da bei einem integrierten Bipolartransistor keine pararitäre Kapazität zwischen Kollektor und Emitter existiert und bei niederohmiger Basis (große Struktur) kein Übersprechsignalpfad zwischen Kollektor und Emitter bei T10 vorhanden ist. Dies wird vorteilhafterweise unterstützt durch hochfrequenzmäßige Erdung der Basis von T10. Die hohe Rückwärtsisolation garantiert auch bei nicht angepaßten Ein- und/oder Ausgangstoren stabilen Betrieb im weiten Grenzen (unilateralter Verstärker).

Die vorstehend am Beispiel eines direkt umsetzenden Empfängers beschriebenen Komponenten sind nicht auf diesen Einsatzfall beschränkt, sondern auch einzeln anderweitig verwendbar.

## Patentansprüche

1. Schaltungsanordnung zur Frequenzumsetzung eines Nutzsignals mit einem Überlagerungssignal nach dem Prinzip der Quadratursignalverarbeitung in einem Modulator oder Demodulator, wobei zur Erzeugung von Quadratur-Überlagerungssignalen ein Überlagerungssignalgenerator (TG) mit einem ersten Regelkreis zur Stabilisierung der 90°-Phasenverschiebung der beiden Quadratur-Überlagerungssignale (TI, TQ) vorgesehen ist, dadurch gekennzeichnet, daß der Überlagerungssignalgenerator einen weiteren Regelkreis zur Erzeugung eines aus einem Oszillatorsignal (LO) abgeleiteten und dem ersten Regelkreis zugeführten Signals mit einem Tastverhältnis von 0,5 aufweist.

2. Schaltungsanordnung nach Anspruch 1, dadurch gekennzeichnet, daß der weitere Regelkreis einen durch das Oszillatorsignal (LO) angesteuerten Verstärker (LV) aufweist, dem ein Symmetriedetektor (SD) nachgeschaltet ist, der das Tastverhältnis des dem ersten Regelkreis zugeführten Signals am Verstärkerausgang detektiert und dieses durch Ansteuern des Verstärkers (LV) auf ein Tastverhältnis von 0,5 regelt.

3. Schaltungsanordnung nach Anspruch 2, dadurch gekennzeichnet, daß der Verstärker ein Begrenzerverstärker ist.

4. Schaltungsanordnung nach einem der Ansprüche 1 bis 3, dadurch gekennzeichnet, daß ein Quadraturphasenteiler vorhanden ist, der in Serie einen Frequenzverdoppler und ein Master-Slave-D-Flip-Flop enthält, daß das Ausgangssignal der Master-Stufe das eine (TI), das Ausgangssignal der Slave-Stufe das andere (TQ) der beiden Quadratur-Überlagerungssignale bildet, und daß über den Regelkreis mit einem Phasendetektor (PD) die gegenseitige 90°-Phasenlage der beiden Quadratur-Überlagerungssignale detektiert und erforderlichenfalls nachgeregelt wird.

5. Schaltungsanordnung nach Anspruch 4, dadurch gekennzeichnet, daß die Master- und die Slave-Stufe durch je einen Stromschalter (T21, T22 bzw. T23, T24) angesteuert sind, deren entsprechende Eingänge miteinander verbunden und mit dem Ausgangssignal der Frequenzverdopplerstufe (FD) beaufschlagt sind, und daß der Regelkreis durch Beeinflussung der Gleichspannungspegel an den Eingängen der Stromschalter die Schaltzeitpunkte der Stromschalter zeitlich äquidistant einregeln.

6. Schaltungsanordnung nach Anspruch 5, dadurch gekennzeichnet, daß der Regelkreis einen weiteren Stromschalter (T25,T26) enthält, der dieselben Schalteigenschaften wie die beiden erstgenannten Stromschalter besitzt und dessen Eingänge mit den entsprechenden Eingängen der beiden anderen Stromschalter verbunden sind.

7. Schaltungsanordnung nach Anspruch 6 , dadurch gekennzeichnet, daß als Ist-Wert des Regelkreises für die relative zeitliche Lage der Schaltzeitpunkte die tiefpaßgefilterten Ausgangsspannungen (u, u′) des weiteren Stromschalters ausgewertet werden.

8. Schaltungsanordnung nach einem der Ansprüche 1 bis 7, dadurch gekennzeichnet, daß für eine Quadraturdemodulatoranordnung ein von einem vorverstärkten Empfangssignal angesteuerter Spannungs-Strom-Wandler mit regelbarer Verstärkung sowie eine Quadraturmischeranordnung mit zwei Einzelmischern vorhanden ist, wobei jeder Mischer von einem der beiden Quadraturüberlagerungssignale angesteuert ist und über eine Aufteilstufe der Ausgangsstrom des Spannungs-/Strom-Wandlers zu gleichen Teilen den beiden Einzelmischern als Betriebsstrom zugeführt ist.

9. Schaltungsanordnung nach Anspruch 8, dadurch gekennzeichnet, daß der Vorverstärker für das Empfangssignal zwei in Reihe geschaltete Basisstufen aufweist, wobei die eingangsseitige Basisstufe mit einem größeren Transistor (T10) und die ausgangsseitige mit einem kleineren Transistor (T11) aufgebaut ist.

10. Schaltungsanordnung nach einem der Ansprüche 1 bis 9, dadurch gekennzeichnet, daß sie als monolithische integrierte Schaltung ausgeführt ist.

## Claims

1. A circuit arrangement for the frequency conversion of a useful signal with a heterodyne signal in accordance with the principle of quadrature signal processing in a modulator or demodulator, where, for the generation of quadrature heterodyne signals, a heterodyne signal generator (TG) is provided with a first control circuit for the stabilisation of the 90°-phase shift of the two quadrature heterodyne signals (TI, TQ), characterised in that the heterodyne signal generator comprises a further control circuit for the generation of a signal with a mark-space ratio of 0.5 which is derived from an oscillator signal (LO) and is supplied to the first control circuit.

2. A circuit arrangement as claimed in Claim 1, characterised in that the further control circuit comprises an amplifier (LV) which is controlled by the oscillator signal (LO) and which is connected at its output end to a symmetry detector (SD) which detects the mark-space ratio of the signal supplied to the first control circuit at the amplifier output and adjusts the latter to a mark-space ratio of 0.5 by control of the amplifier (LV).

3. A circuit arrangement as claimed in Claim 2, characterised in that the amplifier is a limiter amplifier.

4. A circuit arrangement as claimed in one of Claims 1 to 3, characterised in that a quadrature phase divider is provided which comprises, in series, a frequency doubler and a master-slave-D-flip-flop, that the output signal of the master stage forms the one (TI) of the two quadrature heterodyne signals, and the output signal of the slave stage forms the other (TQ) of the two quadrature heterodyne signals, and that via the control circuit with a phase detector (PD) the mutual 90°-phase position of the two quadrature heterodyne signals is detected and if necessary re-adjusted.

5. A circuit arrangement as claimed in Claim 4, characterised in that the master stage and the slave stage are in each case controlled by a current switch (T21, T22 and T23, T24), the corresponding inputs of which are connected to one another and supplied with the output signal of the frequency doubler stage (FD), and that by influencing the d.c. voltage levels at the inputs of the current switches the control circuit adjusts the switching times of the current switches to be equidistant in time.

6. A circuit arrangement as claimed in Claim 5, characterised in that the control circuit comprises a further current switch (T25, T26) which possesses the same switching properties as the two first-mentioned current switches and the inputs of which are connected to the corresponding inputs of the two other current switches.

7. A circuit arrangement as claimed in Claim 6, characterised in that the low-pass-filtered output voltages (u, u') of the further current switch are analyzed as actual value of the control circuit for the relative time position of the switching times.

8. A circuit arrangement as claimed in one of Claims 1 to 7, characterised in that for a quadrature demodulator arrangement, a voltage-current converter which is controlled by a pre-amplified received signal and which has adjustable amplification together with a quadrature mixer arrangement with two individual mixers are provided, where each mixer is controlled by one of the two quadrature heterodyne signals and via a dividing stage the output current of the voltage/current converter is fed in equal parts to the two individual mixers as operating current.

9. A circuit arrangement as claimed in Claim 8, characterised in that the preliminary amplifier for the received signal comprises two series-connected base stages, where the input-end base stage is constructed with a relatively larger transistor (T10) and the output-end base stage is constructed with a relatively smaller transistor (T11).

10. A circuit arrangement as claimed in one of Claims 1 to 9, characterised in that it is manufactured as a monolithic integrated circuit.

## Revendications

1. Circuit de conversion en fréquence d'un signal utile avec un signal de superposition selon le principe du traitement de signaux en quadrature dans un modulateur ou un démodulateur, dans lequel, en vue de la génération de signaux de superposition en quadrature, est prévu un générateur de signaux de superposition (TG) équipé d'un premier circuit de réglage en vue de la stabilisation du déphasage à 90° des deux signaux de superposition en quadrature (TI, TQ), caractérisé en ce que le générateur de signaux de superposition comporte un autre circuit de réglage en vue de la génération d'un signal extrait d'un signal d'oscillateur (LO) et du signal appliqué au premier circuit de réglage avec un rapport cyclique de 0,5.

2. Circuit selon la revendication 1, caractérisé en ce que l'autre circuit de réglage comporte un amplificateur (LV) commandé par le signal d'oscillateur (LO), en aval duquel est disposé un détecteur de symétrie (SD), qui détecte le rapport cyclique du signal appliqué au premier circuit de réglage à la sortie de l'amplificateur et règle celui-ci par commande de l'amplificateur (LV) à un rapport cyclique de 0,5.

3. Circuit selon la revendication 2, caractérisé en ce que l'amplificateur est un amplificateur limiteur.

4. Circuit selon l'une des revendications 1 à 3, caractérisé en ce qu'un diviseur de phase en quadrature est prévu, qui comporte en série un doubleur de fréquence et une bascule D maître-esclave, en ce que le signal de sortie de l'étage maître forme l'un (TI), le signal de sortie de l'étage esclave forme l'autre (TQ) des deux signaux de superposition en quadrature, et en ce que, par l'intermédiaire du circuit de réglage équipé d'un détecteur de phase (PB), la position de phase de 90° réciproque des deux signaux de superposition en quadrature est détectée et, en cas de besoin, post-réglée.

5. Circuit selon la revendication 4, caractérisé en ce que l'étage maître et l'étage esclave sont commandés respectivement par un commutateur de courant (T21, T22, respectivement T23, T24), dont les entrées correspondantes sont réunies et sont alimentées par le signal de sortie de l'étage doubleur de fréquence (FD), et en ce qu'à l'aide du circuit de réglage par influence du niveau de tension continue aux entrées des commutateurs de courant les instants de commutation des commutateurs de courant sont réglés de façon équidistante temporellement.

6. Circuit selon la revendication 5, caractérisé en ce que le circuit de réglage comporte un autre commutateur de courant (T25, 726), qui possède les mêmes propriétés de commutation que les deux commutateurs de courant cités en premier lieu et dont les entrées sont réunies aux entrées correspondantes des deux autres commutateurs de courant.

7. Circuit selon la revendication 6, caractérisé en ce qu'en tant que valeur de consigne du circuit de réglage pour la position temporelle relative des instants de commutation sont évaluées les tensions de sortie filtrées passe-bas (u, u') de l'autre commutateur de courant.

8. Circuit selon l'une des revendications 1 à 7, caractérisé en ce que pour un modulateur en quadrature est prévu un convertisseur courant-tension commandé par un signal d'entrée préamplifié à amplification réglable ainsi qu'un mélangeur en quadrature équipé de deux mélangeurs particuliers, chaque mélangeur étant commandé par un des deux signaux de superposition en quadrature et par l'intermédiaire d'un étage de répartition, le courant de sortie du convertisseur tension/courant étant appliqué en parties égales aux deux mélangeurs particuliers en tant que courant de fonctionnement.

9. Circuit selon la revendication 8, caractérisé en ce que le préamplificateur présente, pour le signal de réception, deux étages fondamentaux disposés en série, l'étage fondamental côté entrée étant réalisé avec un transistor plus grand (T10) et l'étage côté sortie étant réalisé avec un transistor plus petit (T11).

10. Circuit selon l'un des revendications 1 à 9, caractérisé en ce qu'il est réalisé sous la forme d'un circuit intégré monolithique.
